# EUROPEAN PATENT APPLICATION

(11) **EP 3 897 085 A1**
(43) Date of publication of application: **20.10.2021**
(21) Application number: 20197819.4
(22) Date of filing: 23.09.2020
(51) Int. Cl.: H05K 7/20

(54) **ELECTRIC POWER MODULE AND INVERTER APPARATUS HAVING THE SAME**

(30) Priority: 17.04.2020 KR 20200046864
(71) Applicant: LG Electronics Inc., 07336 SEOUL (KR)
(72) Inventor: KIM, Kwangsoo, 08592 Seoul (KR); CHO, Seongmoo, 08592 Seoul (KR); YU, Oksun, 08592 Seoul (KR); HWANG, Hyunsi, 08592 Seoul (KR); CHOI, Siho, 08592 Seoul (KR); LEE, Gun, 08592 Seoul (KR)
(74) Representative: Vossius & Partner Patentanwälte Rechtsanwälte mbB

(57) **Abstract**

The present disclosure relates to an electric power module and an inverter apparatus having the same. The electric power module of the present disclosure may include a power device that converts the frequency of input power for output; a housing in which a passage of cooling fluid is disposed to accommodate the power device therein, and a cooling member, one side of which is in direct heat exchange with the power device, and the other side of which is in direct heat exchange with the cooling fluid, wherein the cooling member is made of a metal foam having a multi-porous structure. As a result, it may be possible to increase a heat transfer area of the heat conductor, and suppress the occurrence of pressure loss in the cooling fluid.

## Description

### BACKGROUND

### 1. Technical Field

The present disclosure relates to an electric power module and an inverter apparatus having the same.

### 2. Description of the Related Art

As is well known, a power device or a power semiconductor device (hereinafter, referred to as a "power device") is a semiconductor device for a power apparatus, and includes a rectifier diode, a power MOSFET, an insulated gate bipolar transistor (IGBT), a thyristor, a gate turn-off thyristor (GTO), a triac, and the like.

An inverter that controls a rotational speed of a motor is typically configured to include the power device to convert the frequency of a power source.

The power device is provided with a cooling apparatus to prevent a decrease in performance due to high temperature because the heat dissipation amount is large during driving.

The power device is typically implemented in a rectangular parallelepiped shape, and provided with a heat dissipation apparatus so-called a heat sink for cooling on a surface of the power device.

The heat sink may be naturally cooled by the surrounding air, or may be forcibly cooled by a cooling fan provided in the surrounding area to promote the movement of air.

Furthermore, in some inverters, a passage of cooling fluid may be configured to exchange heat with liquid-phase cooling fluid (cooling water) at one side of the heat sink.

In addition, in some power devices, a cooling structure in which a plurality of ribbons alternately arranged with concave and convex portions are coupled is applied to a surface of the power device.

However, in such a power device having ribbons in the related art, the ribbons may be coupled (ultrasonically bonded) while applying a relatively high pressure to the surface of the power device, resulting in deformation and/or damage of the power device.

In addition, in some of these power devices, a pin-fin structure is applied to the surface of the power device to use a cooling structure in which the pin-fin structure exchanges heat with cooling water.

However, in such a power device having a pin-fin structure in the related art, an expensive manufacturing process (an integrated casting method or a powder pressing method using metal powder) is applied to form the pin-fin structure, thereby significantly increasing the manufacturing cost of the device.

Moreover, in case where the number of pins coupled to or integrally formed on a surface of the power device is increased, there is a problem that a flow resistance of cooling fluid moving along a passage of the cooling fluid increases.

Accordingly, there is a problem that the capacity and power consumption of a pump for the flow of the cooling fluid is increased.

In consideration of this problem, there is a limitation in reducing the temperature of the power device when the heat dissipation amount of the power device is significantly large because there is a limitation in increasing the number of pins coupled to or integrally formed on the surface of the power device.

In particular, there is a problem that a local temperature increase on the surface of the power device results in functional deterioration or shortened life of a circuit device in the local temperature rise region.

### [Citation List]

### [Patent Documents]

(Patent Document 1) KR1020180028109 A
(Patent Document 2) KR101692490 B1

### SUMMARY

Accordingly, an aspect of the present disclosure is to provide an electric power module capable of increasing a heat transfer area of a heat conductor and suppressing the occurrence of pressure loss in cooling fluid, and an inverter apparatus having the same.

Furthermore, another aspect of the present disclosure is to provide an electric power module capable of suppressing a local temperature increase on a surface of a power device, and an inverter apparatus having the same.

In addition, still another aspect of the present disclosure is to provide an electric power module capable of suppressing the occurrence of variation in heat exchange amount due to a temperature difference of cooling fluid, and an inverter apparatus having the same.

The technical features of an electric power module according to the present disclosure for solving the foregoing problems may include a cooling member formed of a porous metal foam, one side of which directly exchanges heat with a power device, and the other side of which directly exchanges heat with cooling fluid.

Specifically, the electric power module may allow the power device and a cooling member formed of a porous metal foam at one side of the power device to be directly in contact with each other, and the other side of the cooling member to be directly in contact with cooling fluid to exchange heat, thereby increasing a heat transfer area of the power device, and suppressing the occurrence of pressure loss in the cooling fluid passing through the cooling member.

Here, the cooling fluid is composed of cooling water having a high specific heat.

The electric power module may include a power device that converts the frequency of input power for output; a housing in which a passage of cooling fluid is disposed to accommodate the power device therein, and a cooling member, one side of which is in direct heat exchange with the power device, and the other side of which is in direct heat exchange with the cooling fluid, wherein the cooling member is made of a metal foam having a multi-porous structure.

The power device may be provided with a metal plate.

The cooling member may be coupled to the metal plate by soldering or blazing.

As a result, when the cooling member is coupled to the power device, an increase in cost may be suppressed, thereby reducing the manufacturing cost of the electric power module.

The cooling member may be adhered to the metal plate by a thermal conductive adhesive.

As a result, the cooling member may be coupled to the power device at a low cost, thereby reducing the manufacturing cost of the electric power module.

A thermal interface material may be inserted between the cooling member and the metal plate.

As a result, heat transfer between a metal plate of the power device and the cooling member may be promoted.

Metal plates may be provided on both plate surfaces of the power device.

As a result, heat dissipation to both sides of the power device may be increased, thereby increasing the total heat dissipation amount of the power device.

A passage of the cooling fluid may be partitioned into two passages by the power device inside the housing.

As a result, the heat dissipation of the power device may be further promoted.

The housing may be defined such that the passages of cooling fluid are disposed at upper and lower sides of the power device, respectively.

The cooling member may include an upper cooling member disposed at an upper side of the power device and a lower cooling member disposed at a lower side of the power device.

As a result, the cooling of the power device may be further promoted.

Here, the upper cooling member and the lower cooling member may be configured to have different porosity.

The porosity of the upper cooling member may be defined to be larger than that of the lower cooling member in consideration of the heat rising of the power device due to natural convection inside the housing into an upper inner region of the housing.

As a result, the occurrence of temperature deviation between the upper and lower regions of the power device.

A plurality of power devices spaced apart along a plate direction may be provided.

As a result, an increase in the size of the electric power module in a thickness direction may be suppressed.

A cooling fluid inlet port through which the cooling fluid flows in may be disposed on one side along a length direction of the housing, and a cooling fluid outlet port through which the cooling fluid flows out may be disposed on the other side.

The porosity of a cooling member close to the cooling fluid inlet port may be greater than that of a cooling member close to the cooling fluid outlet port.

Accordingly, the porosity of the cooling member exchanging heat with cooling fluid (cooling water) having a relatively low temperature flowing into the cooling fluid inlet port may be set to be relatively larger than that of the cooling member close to the cooling fluid outlet port, thereby suppressing the occurrence of pressure loss of the cooling fluid.

Furthermore, the porosity of the cooling member close to the cooling fluid outlet port may be set to be relatively smaller than that of the cooling member close to the cooling fluid outlet port, thereby reducing a heat exchange amount between cooling fluid (cooling water) having a relatively high temperature and a power device close to the cooling fluid outlet port.

Here, the porosity of the cooling member may have 0.1 to 0.7.

Preferably, the porosity of the cooling member may be configured to have 0.3 to 0.5.

On the other hand, the power device may include a first section having a relatively high surface temperature and a second section having a lower temperature than the first section.

The cooling member may include a first cooling member in heat exchange with the first section and a second cooling member in heat exchange with the second section.

The porosity of the second cooling member may be larger than that of the first cooling member.

As a result, an increase in local temperature in a first section of the power device may be suppressed.

Furthermore, when an entire surface of the power device is used as the first cooling member to lower the temperature of the first section of the power device, pressure loss in cooling fluid may be relatively increased.

According to this configuration, it may be possible to reduce the occurrence of pressure loss in the cooling fluid while suppressing an increase in local temperature on the surface of the power device.

The porosity of the first cooling member and the porosity of the second cooling member may be more than 0.3 and less than 0.5.

Specifically, the first cooling member may be configured to have a porosity of 0.3, and the first cooling member may be configured to have a porosity of 0.5.

According to an embodiment of the present disclosure, the cooling member may further include a third cooling member, one side of which is in contact with the metal plate of the power device and the other side of which is in contact with the first cooling member and the second cooling member.

The porosity of the third cooling member may be smaller than that of the first cooling member and the second cooling member.

As a result, a temperature increase on the surface of the power device may be quickly suppressed.

In addition, it may be possible to reduce the occurrence of pressure loss in the cooling fluid due to the cooling member.

The porosity of the third cooling member may be more than 0.1 and less than 0.3.

According to an embodiment of the present disclosure, the cooling member may further include an outer cooling member disposed at an outer edge of the first cooling member and the second cooling member to accommodate the first cooling member and the second cooling member therein.

A cooling member accommodating portion in which the first cooling member and the second cooling member are accommodated is provided inside the outer cooling member.

The first cooling member and the second cooling member may be in contact with an inner wall of the cooling member accommodating portion in a heat exchangeable manner.

The porosity of the outer cooling member may be larger than that of the first cooling member and the second cooling member.

The porosity of the outer cooling member may be more than 0.5 and less than 0.7.

As a result, it may be possible to increase a heat exchange area between the power device and the cooling fluid without significantly increasing pressure loss in the cooling fluid.

On the other hand, according to another aspect of the present disclosure, there is provided an inverter apparatus, including a case; an electric power module provided inside the case; and a DC-link capacitor provided inside the case to provide DC power to the electric power module.

The electric power module has a plurality of communication pins extending to an outside of the housing, and

A gate board connected to the plurality of communication pins to control the electric power module is provided inside the case.

As described above, according to an embodiment of the present disclosure, one side of a cooling member configured with a metal foam having a multi-porous structure may be directly in contact with a power device and the other side thereof may directly exchange heat with cooling fluid (cooling water), thereby increasing a heat transfer area between the power device and the cooling member as well as suppressing the occurrence of pressure loss in the cooling fluid.

The power device may be provided with a metal plate (ex: copper plate), and the cooling member may be coupled to the metal plate by soldering or blazing, thereby reducing the manufacturing cost of the electric power module.

Furthermore, the cooling member may be coupled to the metal plate by a thermally conductive adhesive, thereby reducing the manufacturing cost of the electric power module.

Furthermore, a thermal interface material may be inserted between the cooling member and the metal plate, thereby reducing air (layer) between the cooling member and the metal plate so as to promote heat dissipation of the power device.

Furthermore, the power device may be provided with metal plates on both sides, and cooling members may be provided on both sides of the power device, and cooling fluid passages may be disposed on both sides of the power device, thereby significantly increasing the heat dissipation amount of the power device.

Furthermore, the housing may be disposed with passages of cooling fluid on upper and lower sides of the power device, and the cooling member may be provided with an upper cooling member and a lower cooling member, thereby controlling a heat exchange amount between upper and lower regions of the power device.

As a result, the occurrence of temperature deviation between the upper and lower regions of the power device may be suppressed.

Furthermore, a cooling fluid inlet port through which the cooling fluid flows in may be disposed on one side along a length direction of the housing, and a cooling fluid outlet port through which the cooling fluid flows out is disposed on the other side, and a porosity of a cooling member close to the cooling fluid inlet port may be configured to be larger than that of a cooling member close to the cooling fluid outlet port, thereby suppressing the occurrence of cooling (temperature) deviation in a power device between upstream and downstream sides along the movement direction of the cooling fluid.

Here, the cooling fluid inlet port is at an upstream side of the cooling fluid outlet port, and the cooling fluid outlet port is at a downstream side of the cooling fluid inlet port.

Furthermore, the occurrence of pressure loss in the cooling fluid inside the housing may be suppressed.

Furthermore, the power device may include a first section having a high surface temperature and a second section having a relatively low temperature, and the cooling member may include a first cooling member that exchanges heat with the first section, and a second cooling member that exchanges heat with the second section, and the porosity of the second cooling member may be configured to be larger than that of the first cooling member, thereby suppressing an increase in local temperature on the surface of the power device as well as suppressing the occurrence of pressure loss in cooling fluid.

Furthermore, the cooling member may further include a third cooling member, one side of which is in contact with a metal plate of the power device and the other side of which is in contact with the first cooling member and the second cooling member, thereby quickly suppressing a temperature increase on the surface temperature of the power device.

Furthermore, it may be possible to suppress the occurrence of pressure loss in cooling fluid inside the housing due to the cooling member.

Furthermore, the cooling member may further include an outer cooling member disposed at an outer edge of the first cooling member and the second cooling member to accommodate the first cooling member and the second cooling member therein, thereby increasing a heat dissipation area of the power device.

Furthermore, the porosity of the outer cooling member may be configured to be larger than that of the first cooling member and that of the second cooling member, thereby suppressing the occurrence of pressure loss in the cooling fluid due to the cooling member inside the housing as well as effectively increasing a heat dissipation area of the power device.

### BRIEF DESCRIPTION OF THE DRAWINGS

FIG. 1 is a cross-sectional view illustrating an inverter apparatus having an electric power module according to an embodiment of the present disclosure.
FIG. 2 is a perspective view illustrating the electric power module in FIG. 1.
FIG. 3 is an exploded perspective view illustrating an electric power module installation area in FIG. 1.
FIG. 4 is a cross-sectional view illustrating an engagement coupling portion in FIG. 2.
FIG. 5 is a perspective view illustrating a coupling state between a power device and a cooling member in FIG. 3.
FIG. 6 is a plan view illustrating the power device in FIG. 5.
FIG. 7 is a perspective view illustrating a first housing from which the power device of FIG. 3 is removed.
FIG. 8 is a plan view of FIG. 7.
FIG. 9 is a cross-sectional view illustrating a coupling state between the power device and the cooling member in FIG. 5.
FIG. 10 is an enlarged cross-sectional view illustrating a coupling region between the power device and the cooling member of FIG. 9.
FIG. 11 is an enlarged cross-sectional view illustrating a coupling region between a power device and a cooling member according to another embodiment of the present disclosure.
FIG. 12 is a cross-sectional view illustrating the electric power module in FIG. 2.
FIG. 13 is an enlarged cross-sectional view illustrating a main portion of an electric power module according to still another embodiment of the present disclosure.
FIG. 14 is a perspective view illustrating an inside of an electric power module according to yet still another embodiment of the present disclosure.
FIG. 15 is a perspective view illustrating a coupling state between a power device and a cooling member in FIG. 14.
FIG. 16 is a plan view of FIG. 15.
FIG. 17 is a view illustrating an inside of an electric power module according to another embodiment of the present disclosure.
FIG. 18 is a plan view illustrating a coupling state between the power device and the cooling member in FIG. 17.
FIG. 19 is a perspective view prior to coupling between a first cooling member and a second cooling member in FIG. 18.
FIG. 20 is a plan view illustrating a coupled state between an electric power module and a cooling member according to still another embodiment of the present disclosure.
FIG. 21 is a perspective view prior to coupling between a first cooling member and a second cooling member in FIG. 20.
FIG. 22 is a plan view illustrating a coupling state between a power device and a cooling member according to still another embodiment of the present disclosure.
FIG. 23 is a perspective view prior to coupling among a first cooling member, a second cooling member, and a third cooling member in FIG. 22.
FIG. 24 is a cross-sectional view of FIG. 22.
FIG. 25 is a plan view illustrating a coupling state between a power device and a cooling member according to still another embodiment of the present disclosure.
FIG. 26 is a perspective view prior to coupling among a first cooling member, a second cooling member, and a fourth cooling member in FIG. 25.
FIG. 27 is a plan view illustrating a coupling state between a power device and a cooling member according to still another embodiment of the present disclosure.
FIG. 28 is a view illustrating a heat conduction cross-sectional area according to a porosity change in the cooling member of the present disclosure and a cooling pin in the related art.
FIG. 29 is a view illustrating a heat transfer surface area of the cooling member of the present disclosure and a cooling pin in the related art.
FIG. 30 is a view illustrating the porosity and the heat dissipation characteristics of the number of holes per inch of the cooling member of the present disclosure.

### DETAILED DESCRIPTION OF THE EMBODIMENTS

Hereinafter, embodiments of the present disclosure will be described in detail with reference to the accompanying drawings. Herein, like reference numerals denote like elements even in different embodiments, and a description for an element appearing first will replace descriptions for like elements appearing later. As used herein, the singular forms "a," "an," and "the" are intended to include the plural forms as well unless the context clearly indicates otherwise. In describing embodiments disclosed in the specification, moreover, the detailed description will be omitted when a specific description for publicly known technologies to which the invention pertains is judged to obscure the gist of the embodiments disclosed in the specification. Also, it should be noted that the accompanying drawings are merely illustrated to easily understand the embodiments disclosed in the specification, and therefore, they should not be construed to limit the technical spirit disclosed in the specification.

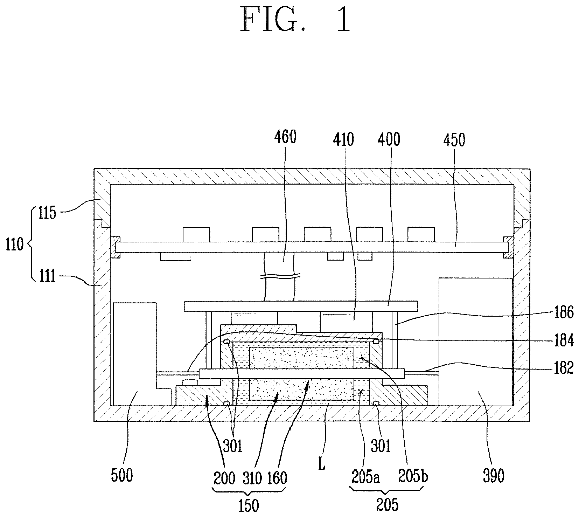

FIG. 1 is a cross-sectional view illustrating an inverter apparatus having an electric power module according to an embodiment of the present disclosure. As illustrated in FIG. 1, an inverter apparatus having an electric power module according to an embodiment of the present disclosure may include a case 110, an electric power module 150, and a DC-link capacitor 390.

The case 110 is implemented in a substantially rectangular parallelepiped shape. The case 110, for example, is configured to be coupled vertically. The case 110 may include an upwardly open body 111 and a cover 115 for opening and closing an opening of the body 111. The cover 115 is defined in a plate shape, for example. The case 110 is configured in a water-insulating manner.

the electric power module 150 is provided inside the case 110. the electric power module 150 may include a power device 160, a housing 200 and a cooling member 310. The DC-Link capacitor 390 for providing DC power to the electric power module 150 is provided on one side of the electric power module 150. A gate board 400 is provided at an upper side of the electric power module 150. A control board 450 is provided at an upper side of the gate board 400. The gate board 400 and the control board 450 are connected by a communication line 460 to enable mutual communication. Another one side of the electric power module 150 is provided with a sensing unit 500 for sensing output power. An input terminal 182 is provided at one side of the electric power module 150. The input terminal 182 is connected to the DC-link capacitor 390. An output terminal 184 is provided at the other side of the electric power module 150. The output terminal 184 is connected to the sensing unit 500.
the electric power module 150 may include a housing 200, a power device 160 provided inside the housing 200, and a cooling member 310. A passage 205 of cooling fluid (L) is disposed inside the housing 200 to move the cooling fluid (L). The passage 205 includes an upper passage 205a and a lower passage 205b. The power device 160 is configured to convert the frequency of input power for output. The power device 160 is configured to convert DC power to AC power for output. The power device 160 is composed of, for example, an insulated/isolated gate bi-polar transistor (IGBT) or a power SiC module.

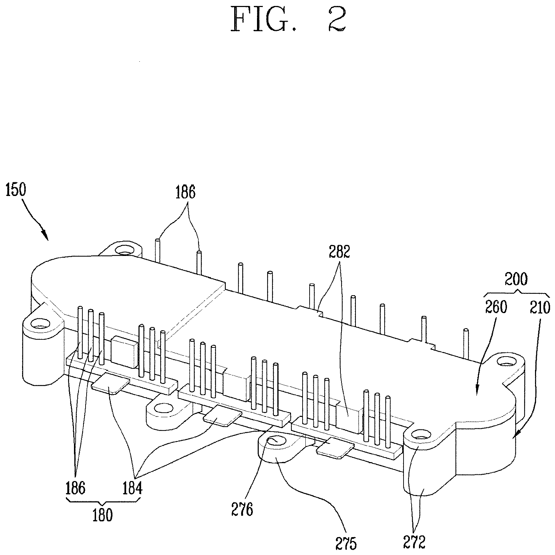

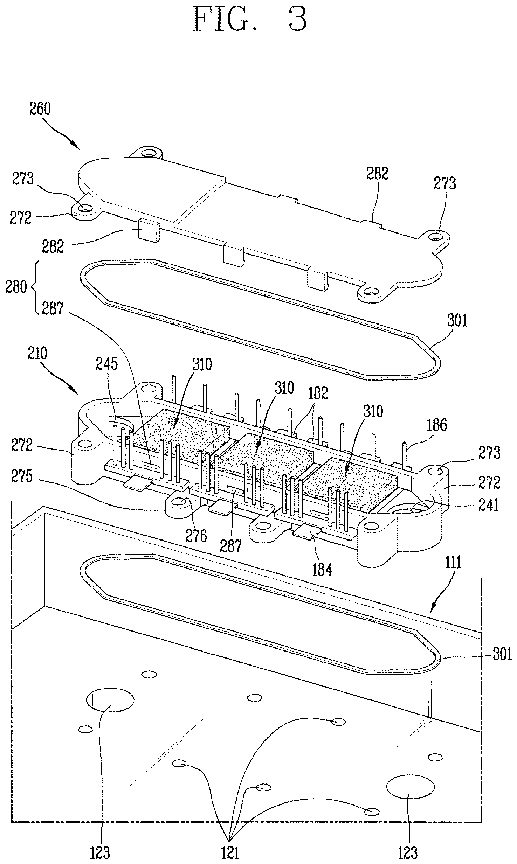

FIG. 2 is a perspective view illustrating the electric power module in FIG. 1, and FIG. 3 is an exploded perspective view illustrating an electric power module installation area in FIG. 1. As illustrated in FIGS. 2 and 3, the electric power module 150 may include a housing 200 that constitutes an accommodation space therein. The housing 200 may be configured to be separated and coupled along a thickness direction thereof. The housing 200 may include a first housing 210 and a second housing 260 coupled to each other.

The first housing 210 may be implemented for example, an upwardly open cylindrical shape. The first housing 210 may be formed of a synthetic resin member, for example. The second housing 260 may be implemented, for example, in a plate shape that opens and closes an upper opening of the first housing 210. The second housing 260 may be formed of a synthetic resin member or a metal member, for example. In the present embodiment, the second housing 260 is formed of an aluminum (Al) member. As a result, heat exchange between the second housing 260 and the surroundings may be promoted. Since the second housing 260 is heat exchange with the cooling fluid (L) therein, the temperature may be relatively low, thereby absorbing the surrounding heat to cooling the surroundings.

A circuit component 410 of the gate board 400 is disposed on an upper surface of the second housing 260 in contact therewith. The circuit component 410 may be, for example, a circuit device having a large heat dissipation amount. As a result, the cooling of the circuit component 410 in the gate board 400 may be promoted.

A plurality of power devices 160 may be provided inside the first housing 210. In the present embodiment, the plurality of power devices 160 are implemented in three. The three power devices 160 may be configured to output U-phase, V-phase, and W-phase, respectively, of a three-phase AC power source.

The plurality of power devices 160 may be configured to be spaced apart along a plate surface direction. Input terminals 182 for receiving power are provided at one sides of the plurality of power devices 160, respectively. Output terminals 184 for outputting power are provided at the other sides of the plurality of power devices 160, respectively. A plurality of communication pins 186 are provided at both sides (upper and lower sides on the drawing) of the plurality of power devices 160, respectively. The plurality of communication pins 186 are respectively disposed to protrude from an outside of the housing 200. The plurality of communication pins 186 are respectively disposed to protrude in a thickness direction of the power device 160. The plurality of communication pins 186 are respectively connected to the gate board 400 in a communicable manner.

A passage 205 of the cooling fluid (L) is disposed inside the housing 200 to flow the cooling fluid (L). The housing 200 is configured such that passages 205a, 205b of the cooling fluid (L) are disposed at upper and lower sides of the power device 160, respectively.

A cooling fluid inlet port 241 through which the cooling fluid (L) flows into the housing 200 is disposed at one side (right side on the drawing) along a length direction of the housing 200. A cooling fluid outlet port 245 through which the cooling fluid (L) inside the housing 200 flows is disposed at the other side (left side on the drawing) along the length direction of the housing 200.

The case 110 is provided with a communication hole 123 communicating with the cooling fluid inlet port 241.

The case 110 is provided with a communication hole 123 communicating with the cooling fluid outlet port 245.

The communication holes 123 of the case 110 are respectively connected to communication pipes 125 of a cooling fluid movement path through which the cooling fluid moves.

A sealing member 301 is provided between the case 110 and the housing 200 to suppress the leakage of the cooling fluid (L). The sealing member 301 is disposed along an edge of the first housing 210. The sealing member 301 has a closed loop shape.

The sealing member 301 is provided in a mutual contact region between the first housing 210 and the second housing 260 to suppress the leakage of the cooling fluid (L). The sealing member 301 is disposed along an edge of the first housing 210 and the second housing 260. The sealing member 301 is implemented in a closed loop shape.

The first housing 210 is provided with a plurality of first coupling portions 272 to be coupled to the second housing 260 and the case 110. Fastening member inserting portions 273 are respectively disposed at the plurality of first coupling portions 272 to pass therethrough so as to allow fastening members to be inserted thereinto. The first coupling portions 272 are disposed at each of four corners of the first housing 210 and the second housing 260, respectively.

The first housing 210 is provided with a second coupling portion 275 to be coupled to the case 110. Fastening member inserting portions 276 are respectively disposed at second coupling portions 275 to pass therethrough so as to allow fastening members to be inserted thereinto. The second coupling portions 275 are provided at both sides of the center of the first housing 210, respectively.

As illustrated in FIG. 3, the case 110 has fastening member coupling portions 121 to allow fastening members coupled to the first coupling portion 272 and the second coupling portion 275, respectively, to be coupled thereto.

On the other hand, the first housing 210 and the second housing 260 is provided with an engagement coupling portion 280 that is mutually engaged. The engagement coupling portion 280 includes a hook 282 protruding from the second housing 260 and a hook coupling portion 287 through which the hook 282 is coupled to the first housing 210.

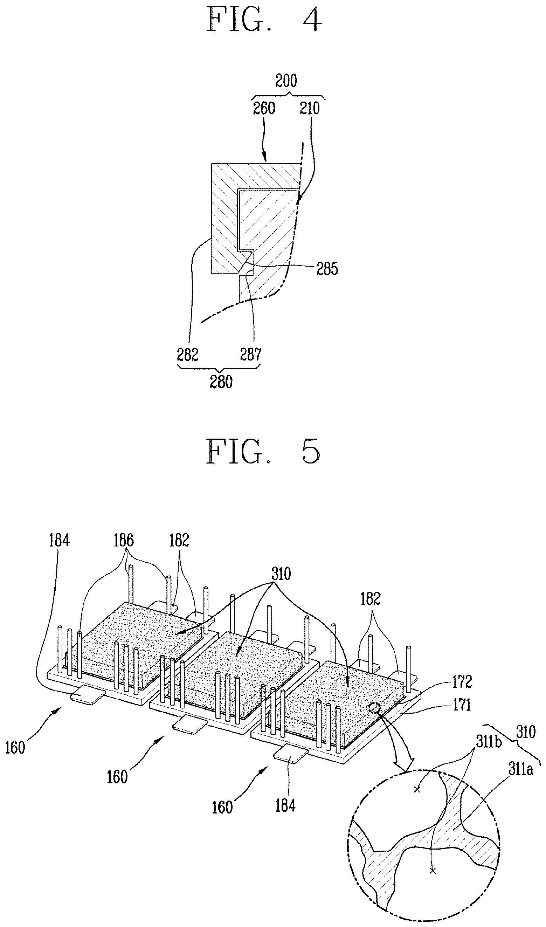

FIG. 4 is a cross-sectional view illustrating an engagement coupling portion in FIG. 2. As illustrated in FIG. 4, the hook coupling portion 287 is recessed on both sides of the first housing 210, respectively. The hooks 282 are respectively disposed to protrude downward from both sides of the first housing 210 toward the first housing 210.

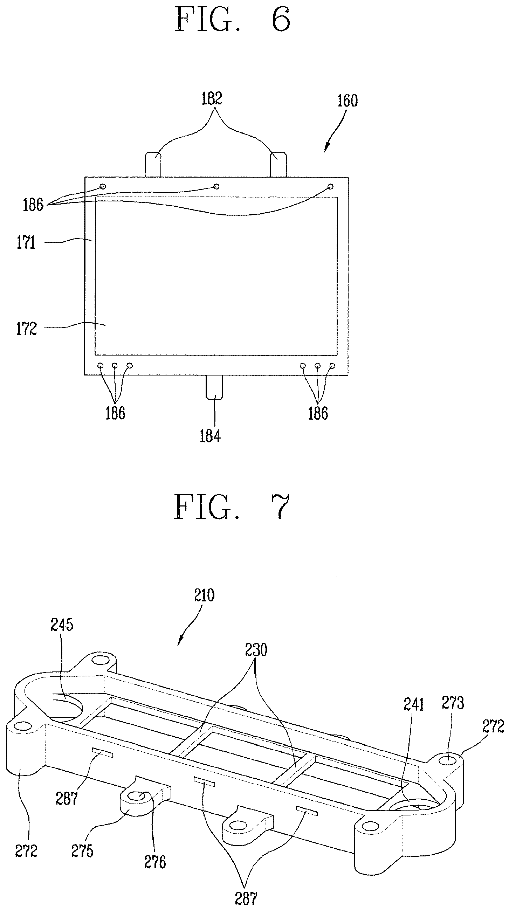

FIG. 5 is a perspective view illustrating a coupling state between a power device and a cooling member in FIG. 3, and FIG. 6 is a plan view illustrating the power device in FIG. 5. As illustrated in FIGS. 5 and 6, the power device 160 includes a thin rectangular parallelepiped body 171 and metal plates 172 provided on both plate surfaces of the body 171. A plurality of circuit devices 162 are provided inside the body 171. The body 171 may be formed of, for example, an insulating material. As a result, the plurality of circuit devices 162 inside the body 171 being brought into direct contact with moisture may be suppressed. The metal plate 172 is implemented with, for example, a copper plate. The input terminal 182 is provided at one side (upper side on the drawing) of the body 171. The output terminal 184 is provided at the other side (lower side on the drawing) of the body 171. The communication pins 186 are provided at both sides of the body 171, respectively.

A cooling member 310 is coupled to the metal plate 172 of the power device 160. The cooling member 310 is configured to include a cooling member 310 brought into direct contact with the metal plate 172 in a heat exchangeable manner. The cooling member 310 is implemented, for example, with a metal foam having a multi-porous structure. The cooling member 310 may include a metal portion 311a and a plurality of void holes 311b disposed between the metal portions 311a. Here, the plurality of void holes 311b are configured in an open type to be able to pass through the cooling fluid (L). The cooling member 310 is configured to have, for example, a porosity of 0.1 to 0.7. The cooling member 310 is composed of, for example, 30 to 90 void holes 311b per inch.

Accordingly, the cross-sectional area of heat transfer through the cooling member 310 of the power device 160 may be increased, thereby promoting the heat dissipation of the power device 160.

Furthermore, the movement of the cooling fluid (L) may be allowed through the void holes 311b) of the cooling member 310, thereby significantly reducing the occurrence of pressure loss in the cooling fluid (L).

The porosity, as is well known, denotes a ratio of the volume of the void holes 311b in the cooling member 310 to the volume of the cooling member 310. The porosity may denote the sum of the cross-sectional areas of the void holes 311b per unit area. When the volume (or unit area) of the cooling member 310 is 1, the volume (sum of the cross-sectional areas) of the void holes 311b in the cooling member 310 may be 0.1 to 0.7.

Preferably, the porosity of the cooling member 310 may be 0.3 to 0.5.

According to this configuration, a heat transfer cross-sectional area of the cooling member 310 (a cross-sectional area of the metal portion 311a) may be increased, thereby promoting the heat dissipation (or heat exchange) of the power device 160. Moreover, the movement of the cooling fluid (L) through the void holes 311b in the cooling member 310 may be promoted, thereby significantly reducing the occurrence of pressure loss in the cooling fluid (L).

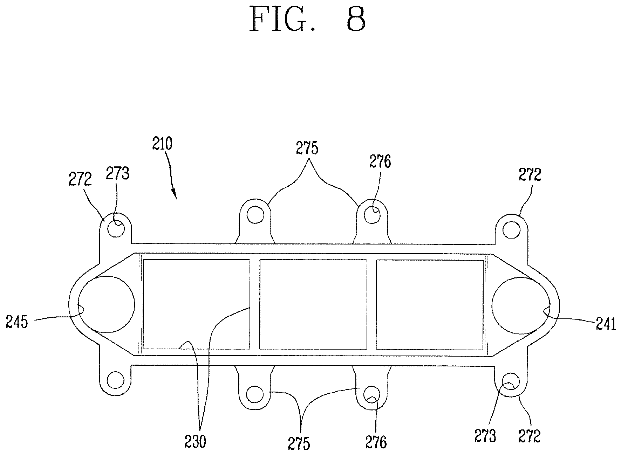

FIG. 7 is a perspective view illustrating a first housing from which the power device of FIG. 3 is removed, and FIG. 8 is a plan view of FIG. 7. As illustrated in FIGS. 7 and 8, inside the housing 200 (the first housing 210), the power devices 160 are arranged to be spaced apart along a plate surface direction. The first housing 210 may be manufactured by, for example, injection molding a synthetic resin member around the plurality of power devices 160. Furthermore, the first housing 210 may be constructed by pre-molding a synthetic resin member, and coupling the plurality of power devices 160 thereto

An edge covering portion 230 is disposed inside the first housing 210 to surround a periphery (four sides) of the plurality of power devices 160 spaced apart from each other along a plate surface direction.

Each of the power devices 160 may be configured such that four sides of the body 171 excluding the metal plate 172 are covered by the edge covering portion 230.

The passages 205 of the cooling fluid (L) are disposed at upper and lower sides of the edge covering portion 230 and the plurality of power devices 160, respectively.

Referring back to FIG. 1, the passages 205 inside the housing 210 may be partitioned into an upper passage 205a and a lower passage 205b by the edge covering portion 230 and the power device 160.

The cooling fluid inlet port 241 is disposed to pass through one side of the first housing 210. The cooling fluid outlet port 245 is disposed to pass through the other side of the first housing 210.

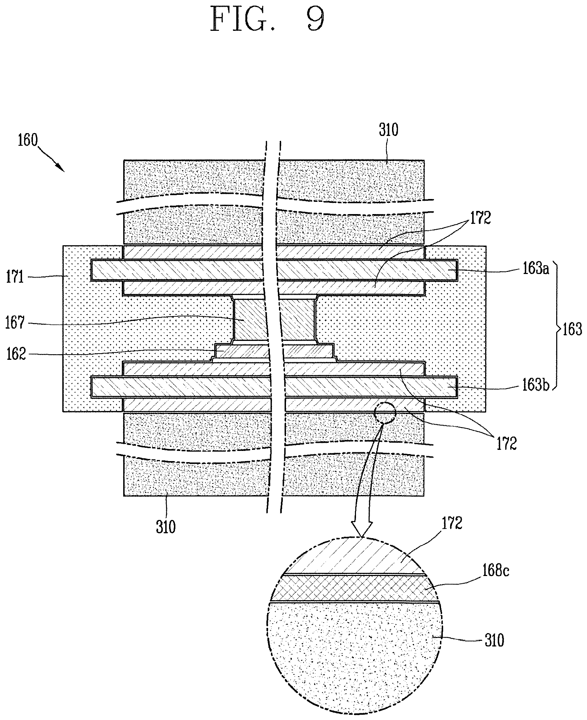

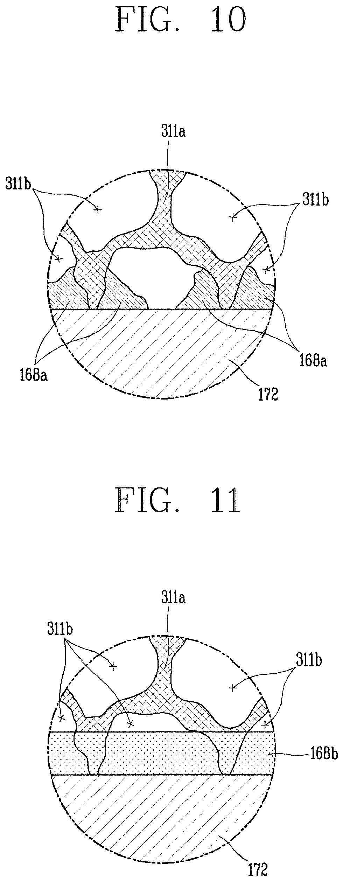

FIG. 9 is a cross-sectional view illustrating a coupling state between the power device and the cooling member in FIG. 5, and FIG. 10 is an enlarged cross-sectional view illustrating a coupling region between the power device and the cooling member of FIG. 9. As illustrated in FIG. 9, the power device 160 is provided with a body 171, a circuit device 162 (chip) provided inside the body 171, and metal plates 172 disposed to externally exposed on both plate surfaces of the body 171.

The circuit device 162 may be implemented, for example, as a MOSFET die. A lower insulating substrate 163b is provided on one side (lower side on the drawing) of the circuit device 162. The metal plate 172 is provided between the circuit device 162 and the lower insulating substrate 163b. The metal plate 172 is provided at an outer side of the lower insulating substrate 163b. An outer surface of the metal plate 172 disposed at a lower side of the lower insulating substrate 163b is externally exposed on a bottom surface of the body 171. The cooling member 310 is directly brought into contact with the metal plate 172 exposed to a bottom surface of the body 171 to enable heat transfer.

An upper insulating substrate 163a is provided at the other side (upper side on the drawing) of the circuit device 162. A spacer 167 is provided between the circuit device 162 and the upper insulating substrate 163a. As a result, the upper insulating substrate 163a may be spaced apart from the circuit device 162 at a predetermined distance. The metal plate 172 is provided between the upper insulating substrate 163a and the spacer 167. The metal plate 172 is provided at an upper side of the upper insulating substrate 163a. The metal plate 172 disposed at an upper side of the upper insulating substrate 163a has an outer surface exposed to an outside of the upper surface of the body 171. The cooling member 310 is directly brought into contact with the metal plate 172 exposed to an upper surface of the body 171 to enable heat transfer. Here, the metal plates 172 disposed at both sides of the insulating substrate (the upper insulating substrate 163a and the lower insulating substrate 163b) are respectively implemented with copper plates.

Here, a thermal interface material 168c may be inserted between the cooling member 310 and the metal plate 172 disposed on bottom and top surfaces of the body 171, respectively. As a result, heat transfer between the metal plate 172 and the cooling member 310 may be promoted.

The thermal interface material 168c is implemented with, for example, a thermal compound or thermal grease. As a result, the amount of air (air layer), which is an insulating material existing between the metal plate 172 and the cooling member 310 in the power device 160 may be reduced to promote heat transfer between the power device 160 and the cooling member 310.

Accordingly, the cooling of the power device 160 may be promoted.

As illustrated in FIG. 10, the cooling member 310 may include a metal portion 311a and a plurality of void holes 311b disposed between the metal portions 311a. The cooling member 310 and the metal plate 172 may be coupled by, for example, blazing. As a result, the cooling member 310 may be integrally fixed to the power device 160. Blazing coupling portions 168a are respectively disposed around the metal member 311a of the cooling member 310 in contact with the metal plate 172.

FIG. 11 is an enlarged cross-sectional view illustrating a coupling region between a power device and a cooling member according to another embodiment of the present disclosure. As illustrated in FIG. 11, the cooling member 310 may include a metal portion 311a and a plurality of void holes 311b disposed between the metal portions 311a. A thermally conductive adhesive 168b is provided between the contact surfaces of the cooling member 310 in contact with the metal plate 172. As a result, the cooling member 310 may be integrally fixed to the power device 160. In addition, thermal energy generated by the circuit device 162 and transferred to the metal plate 172 may be rapidly transferred by the metal portion 311a of the cooling member 310 and the thermally conductive adhesive 168b, thereby promoting the heat dissipation of the power device 160.

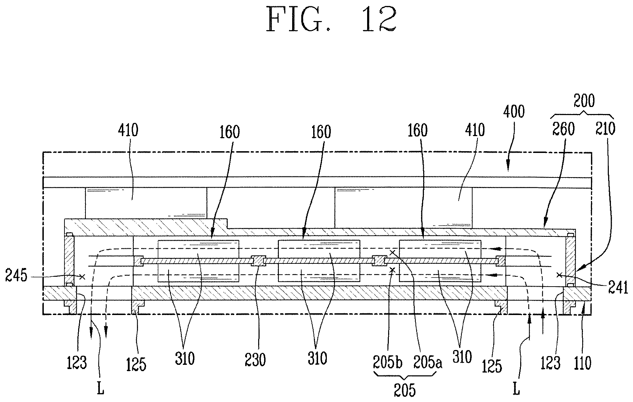

FIG. 12 is a cross-sectional view illustrating the electric power module in FIG. 2. As illustrated in FIG. 12, the second housing 260 is disposed to block an upper opening of the first housing 210. The first housing 210 and the second housing 260 are integrally coupled by the engagement coupling portion 280. The hooks 282 of the second housing 260 are respectively coupled to the hook coupling portions 287 of the first housing 210.

The first housing 210 coupled to the second housing 260 is disposed inside the case 110. Here, the first housing 210 is disposed such that the cooling fluid inlet port 241 and the cooling fluid outlet port 245 communicate with the communication holes 123 of the case 110, respectively.

Fastening members are inserted into the first coupling portion 272 and the second coupling portion 275, respectively, and coupled to the corresponding fastening member coupling portions 121 of the case 110, respectively.

Meanwhile, when the power (DC power) of the DC-link capacitor 390 is input to the power device 160 through the input terminal 182, the frequency is converted by the power device 160. The power (AC power) whose frequency has been changed by the power device 160 is output through the output terminal 184.

When the power device 160 is driven, thermal energy is generated by a heating action, and the temperature of the power device 160 is increased. Thermal energy generated by the power device 160 is transferred to the cooling members 310, respectively, to dissipate heat.

When the operation is initiated, the cooling fluid (L) is introduced into the housing 200 through the cooling fluid inlet port 241. The cooling fluid (L) (cooling water) is cooled through a cooling apparatus (radiator) (not shown) of the cooling fluid (L) to have a relatively low temperature.

Part of the cooling fluid (L) flowing into the housing 200 through the cooling fluid inlet port 241 moves to an upper side of the power device 160, and another part thereof moves to a lower side of the power device 160.

The cooling fluids (L) respectively moved along the upper passage 205a and the lower passage 205b of the power device 160 are respectively in contact with the cooling member 310 to exchange heat with each other. As a result, the cooling member 310 may be quickly cooled. In addition, the power device 160 in contact with the cooling member 310 may be quickly heat dissipated and cooled.

The cooling fluid (L) that has cooled the cooling member 310 while moving through the upper passage 205a and the lower passage 205b of the power device 160 flows out of the housing 200 through the cooling fluid outlet port 245. The cooling fluid (L) flowing out of the housing 200 continuously cools the power device 160 while repeating the process of being cooled while moving along the movement path of the cooling fluid (L), which is not shown, and then, flowing into the housing 200 through the cooling fluid inlet port 241.

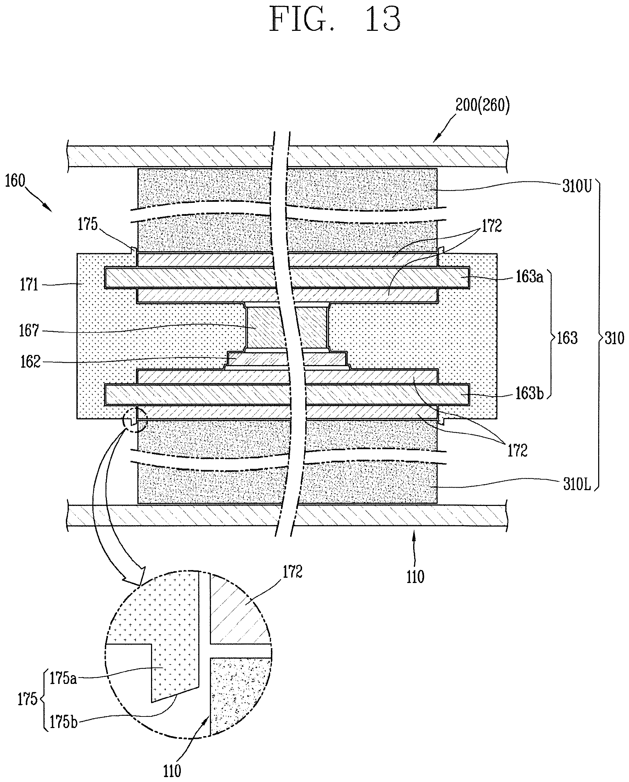

FIG. 13 is an enlarged cross-sectional view illustrating a main portion of an electric power module according to still another embodiment of the present disclosure. As illustrated in FIG. 13, the power device 160 may include a body 171, a circuit device 162 provided inside the body 171, and a lower insulating substrate 163b and an upper insulating substrate 163a provided inside the body 171. A spacer 167 is provided between the circuit device 162 and the upper insulating substrate 163a. The metal plates 172 are provided at both sides of the lower insulating substrate 163b and the upper insulating substrate 163a, respectively.

Meanwhile, a cooling member 310 is provided in direct contact with the metal plates 172 provided on bottom and top surfaces of the power device 160, respectively.

The cooling member 310 may include, for example, an upper cooling member 310U provided at an upper side of the power device 160 and a lower cooling member 310L provided at a lower side of the power device 160.

The upper cooling member 310U and the lower cooling member 310L are made of a metal foam having a multi porous structure.

The porosity of the upper cooling member 310U may be smaller than that of the lower cooling member 310L.

The porosity of the lower cooling member 310L may be larger than that of the upper cooling member 310U.

As a result, a heat transfer area of the metal portion 311a of the upper cooling member 310U may be larger than that of the metal portion 311a of the lower cooling member 310L.

The number of void holes per inch in the upper cooling member 310U may be greater than that of void holes 311 b per inch in the lower cooling member 310L.

The number of void holes 311 b per inch in the lower cooling member 310L may be smaller than that of void holes 311 b per inch in the upper cooling member 310U.

Furthermore, the upper cooling member 310U may be configured to have a smaller porosity than the lower cooling member 310L, and have a larger number of void holes 311b per inch.

In addition, the lower cooling member 310L may be configured to have a larger porosity than the upper cooling member 310U, and have a smaller number of void holes 311b per inch.

According to this configuration, when heat is generated in the power device 160, heat dissipation of heat energy moved to an upper side of the power device 160 may be promoted by natural convection. As a result, an excessive temperature increase in an upper region of the power device 160 may be suppressed.

On the other hand, the cooling member 310 may be configured to be in close contact with the power device 160 (metal plate 172) by pressing the housing 200.

The lower cooling member 310L is configured such that one side (bottom surface on the drawing) is in contact with a bottom surface of the case 110 and the other side is in contact with the metal plate 172 on the bottom surface of the power device 160.

As a result, when the electric power module 150 and the case 110 are coupled to each other, the lower cooling member 310L may be pressed against the bottom surface of the lower cooling member 310L by the case 110 to be in close contact with the bottom surface of the power device 160.

The upper cooling member 310U is configured such that one side (bottom surface on the drawing) is in contact with the metal plate 172 on an upper surface of the power device 160 and the other side is in contact with an inner surface of the second housing 260.

When the second housing 260 and the first housing 210 are coupled to each other while a bottom surface of the upper cooling member 310U is in contact with an upper surface of the power device 160, the upper cooling member 310U may be pressed by an inner surface of the second housing 260 to be in close contact with an upper surface of the power device 160.

The power device 160 is provided with a location guide portion 175 for guiding the location of the cooling member 310. The location guide portion 175 is provided on a bottom surface of the power device 160.

The location guide portion may be configured to guide the lower cooling member 310L to allow the lower cooling member 310L to be in contact the metal plate 172 on a bottom surface of the power device 160 at a preset position, for example.

The location guide portion 175 may include, for example, protruding portions 175a disposed at four sides of the metal plate 172 on a bottom surface of the power device 160. As a result, the occurrence of lateral clearance of the lower cooling member 310L guided inside the location guide portion 175 may be suppressed.

Furthermore, a contact area between the metal plate 172 on a bottom surface of the power device 160 and the lower cooling member 310L is maximized to maximize heat exchange between the power device 160 and the lower cooling member 310L.

The location guide portion 175 may be configured with, for example, a guide inclined surface 175b defined to be inclined inward at an end portion of the protruding portion 175a.

The location guide portion 175 may be provided on an upper surface of the power device 160.

The location guide portion 175 is configured with protruding portions 175a protruding to correspond to four sides of the metal plate 172, respectively, on an upper surface of the power device 160.

The location guide portion 175 is configured with guide inclined surfaces 175b defined to be inclined inward at end portions of the protruding portions 175a, respectively, on an upper surface of the power device 160.

By this configuration, when the electric power module 150 is to be coupled to the case 110, a plurality of upper cooling members 310U are arranged at an upper side of the plurality of power devices 160, respectively, inside the first housing 210. At this time, the plurality of upper cooling members 310U may be guided by the location guide portion 175 to be in contact with the metal plate 172 on an upper surface of the relevant power device 160. When the plurality of upper cooling members 310U are arranged at corresponding positions, the second housing 260 may be pressed downward against an upper opening of the first housing 210. As a result, each hook 282 of the second housing 260 may be coupled to the relevant hook coupling portions 287, respectively.

When the first housing 210 is to be coupled to the case 110, the plurality of lower cooling members 310L are arranged on a bottom surface of the case 110. The first housing 210 coupled to the second housing 260 is disposed at an upper side of the plurality of lower cooling members 310L. At this time, the first housing 210 is placed on an upper surface of the plurality of lower cooling members 310L to allow each communication hole 123 of the case 110 and the cooling fluid inlet port 241 and the cooling fluid outlet port 245 of the first housing 210 to communicate with each other. The plurality of lower cooling members 310L may be respectively contact with and coupled to the metal plate 172 on a bottom surface of the relevant power device 160 by the location guide portion 175. Next, fastening members are inserted through the first coupling portion 272 and the second coupling portion 275 to allow each fastening member to be coupled to the fastening member coupling portions 121 of the case 110, respectively.

Meanwhile, when the operation is initiated, the cooling fluid (L) is introduced into the housing 200 through the cooling fluid inlet port 241 of the housing 200. The cooling fluid (L) introduced into the housing 200 is branched and moved to upper and lower sides of the power device 160, respectively.

The respective power devices 160 may be rapidly cooled by the upper cooling member 310U and the lower cooling member 310L.

Here, thermal energy generated from the power device 160 may move to an upper side of the power device 160 by convection.

At this time, the upper cooling member 310U may be configured to have a smaller porosity than the lower cooling member 310L to increase a heat conduction cross-sectional area thereof, thereby rapidly cooling an upper region of the power device 160.

As a result, the occurrence of temperature deviation between the upper and lower regions of the power device 160 may be suppressed.

In addition, an excessive temperature increase on an upper surface of the power device 160 may be suppressed.

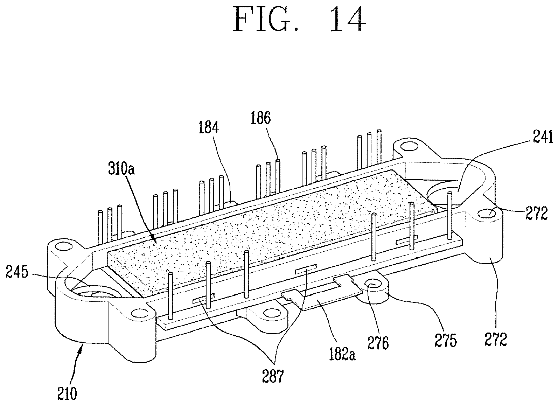

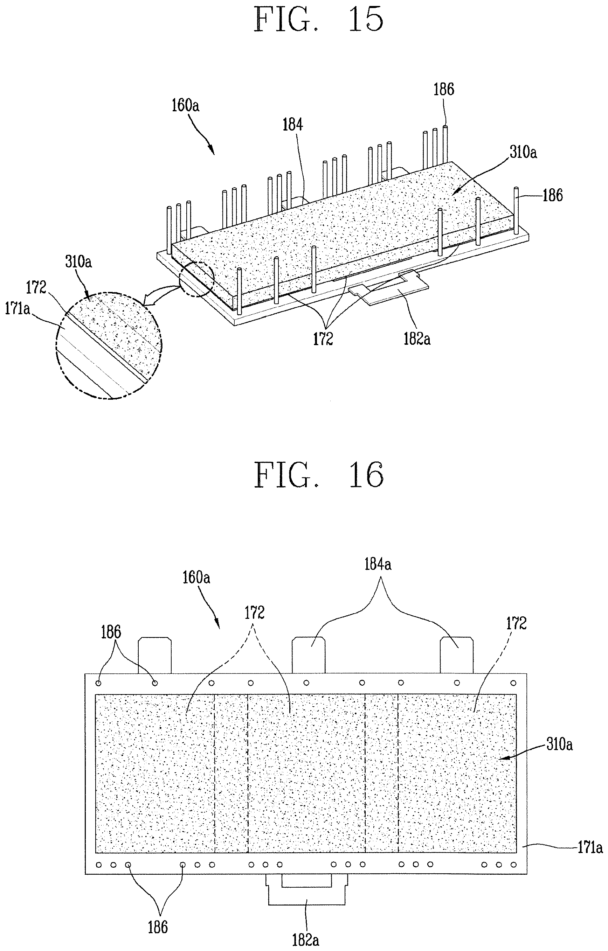

FIG. 14 is a perspective view illustrating an inside of an electric power module according to yet still another embodiment of the present disclosure, and FIG. 15 is a perspective view illustrating a coupling state between a power device and a cooling member in FIG. 14, and FIG. 16 is a plan view of FIG. 15. As illustrated in FIGS. 14 through 16, the electric power module 150 of the present embodiment is configured with a power device 160a, a housing 200, and a cooling member 310.

The power device 160a is configured to have a length larger than a width. The power device 160a is configured to convert DC power into AC power for output. The power device 160a is configured to have three power devices spaced apart along a plate direction. The power device 160a includes a rectangular parallelepiped body 171a having a length corresponding to three power devices, and a plurality of metal plates 172 provided on both plate surfaces of the body 171a.

An input terminal 182 is provided at one side of the body 171a of the power device 160a. The input terminal 182 is integrally formed in a "U" shape.

The output terminal 184 is provided at the other side of the body 171a of the power device 160a. The output terminal 184 is configured with three terminals corresponding to different phases (U phase, V phase, W phase) of AC power.

A plurality of communication pins 186 are provided at both sides of the body 171a of the power device 160a, respectively. The plurality of communication pins 186 are configured to protrude along a thickness direction.

The power device 160a is accommodated in the housing 200. The housing 200 (first housing 210) may be manufactured by injection molding, for example, with the power device 160a therein.

The housing 200 may be configured such that passages of the cooling fluid (L) are disposed at both sides (upper and lower sides on the drawing) of the power device 160, respectively. The passages of the cooling fluid (L) may be partitioned by the power device 160a. A cooling fluid inlet port 241 is disposed at one side (right side on the drawing) along a length direction of the housing 200 to allow the cooling fluid (L) to flow into the housing 200. A cooling fluid outlet port 245 is disposed at the other side (left side on the drawing) along the length direction of the housing 200 to allow the cooling fluid (L) inside the housing 200 to flow out.

Meanwhile, the cooling member 310a is configured to be in direct contact with the metal plate 172 of the power device 160a. One side of the cooling member 310a is in direct contact with the metal plate 172 and the other side thereof is in direct contact with the cooling fluid (L).

The cooling member 310a is made of a metal foam having a multi porous structure.

The cooling member 310a is configured to have, for example, a porosity of 0.1 to 0.7.

The cooling member 310a may preferably have a porosity of 0.3 to 0.5.

The cooling member 310a is provided with an upper cooling member 310a coupled to a metal plate 172 at an upper side of the power device 160a.

The cooling member 310a is provided with a lower cooling member 310a coupled to a metal plate 172 on a bottom surface of the power device 160a.

The upper cooling member 310a may have a smaller porosity than the lower cooling member 310a. As a result, the occurrence of temperature deviation between the upper and lower regions of the power device 160a may be suppressed.

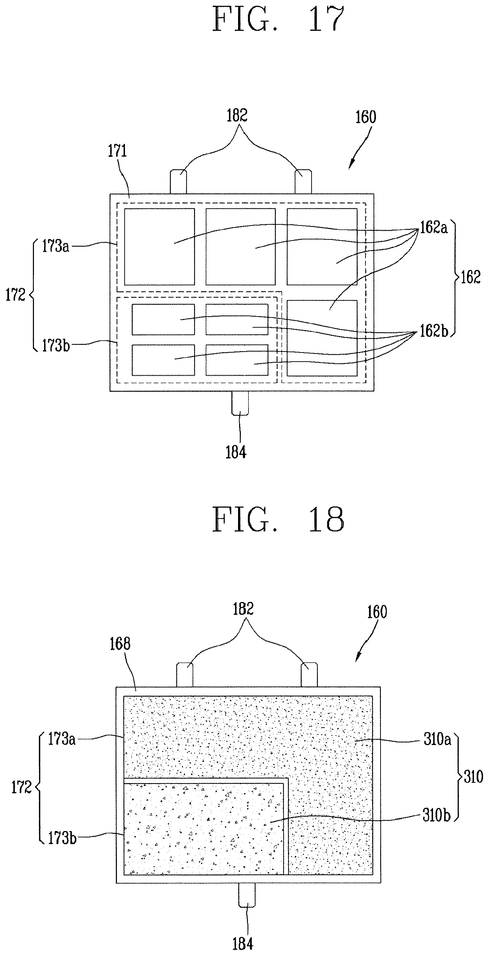

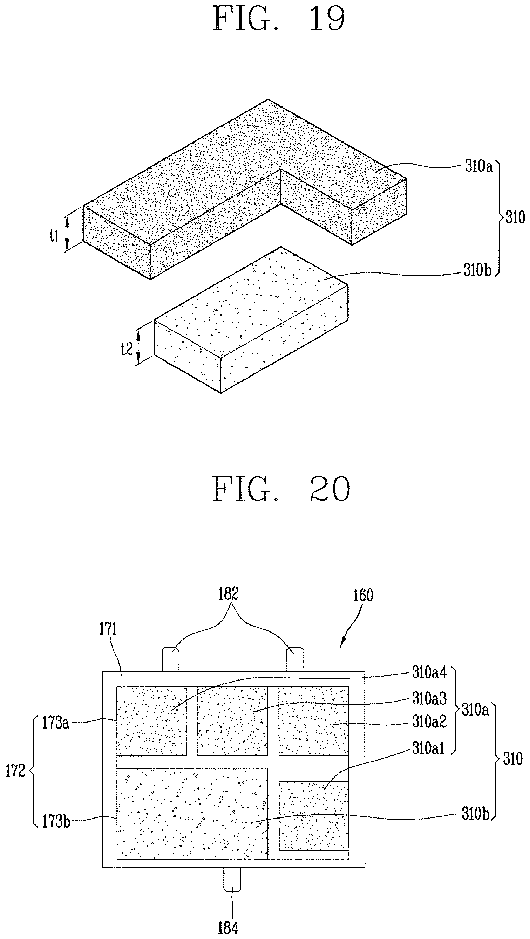

FIG. 17 is a view illustrating an inside of an electric power module according to another embodiment of the present disclosure, and FIG. 18 is a plan view illustrating a coupling state between the power device and the cooling member in FIG. 17, and FIG. 19 is a perspective view prior to coupling between a first cooling member and a second cooling member in FIG. 18. As illustrated in FIG. 17, the power device 160 is configured to have a body 171 and a plurality of circuit devices 162 provided inside the body 171. Metal plates 172 are provided on both plate surfaces of the body 171, respectively. The plurality of circuit devices 162 includes a plurality of switching devices 162a having a circuit switching function and a plurality of diodes 162b having a rectifying function. The plurality of switching devices 162a may be implemented as, for example, MOSFETs.

The plurality of switching devices 162a have, for example, a small rectangular shape compared to the body 171. Each of the plurality of diodes 162b has a smaller rectangular shape than the switching device 162a.

The surface of the power device 160 (metal plate 172) includes a first section 173a having a relatively high temperature and a second section 173b having a lower temperature than the first section 173a. The first section 173a denotes, for example, a surface corresponding to the switching device 162a having a relatively large heat dissipation amount during operation. The second section 173b denotes a surface corresponding to the diode 162b having a relatively small heat dissipation amount during operation.

A cooling member 310 is provided on a surface of the power device 160 to enable direct heat exchange.

The cooling member 310 is made of a metal foam having a multi porous structure.

The cooling member 310 includes, for example, a first cooling member 310a exchanging heat with the first section 173a and a second cooling member 310b exchanging heat with the second section 173b.

The first cooling member 310a and the second cooling member 310b may be configured to have a porosity of 0.1 to 0.7.

The first cooling member 310a and the second cooling member 310b may preferably have a porosity of 0.3 to 0.5.

The first cooling member 310a and the second cooling member 310b may have different porosities.

The porosity of the first cooling member 310a may be smaller than that of the second cooling member 310b.

The porosity of the second cooling member 310b may be larger than that of the first cooling member 310a.

More specifically, the porosity of the first cooling member 310a may be, for example, 0.3 to 0.4.

The porosity of the second cooling member 310b may be, for example, 0.4 to 0.5.

As a result, a heat conduction cross-sectional area of the first cooling member 310a may be larger than that of the second cooling member 310b.

According to this configuration, the heat dissipation amount through the first cooling member 310a may be greater than that through the second cooling member 310b.

In addition, the pressure loss of the cooling fluid (L) generated by the second cooling member 310b may be smaller than that of the cooling fluid (L) generated by the first cooling member 310a.

According to this configuration, the pressure loss of the cooling fluid (L) may be lower compared to a case of cooling an entire surface of the power device 160 with the cooling member 310 having the same porosity as the first cooling member 310a.

Furthermore, the heat dissipation amount of the power device 160 may be increased compared to a case of cooling an entire surface of the power device 160 with the cooling member 310 having the same porosity as the second cooling member 310b, thereby enhancing cooling effect.

As illustrated in FIGS. 18 and 19, the first cooling member 310a has a shape corresponding to that of the first section 173a. In the present embodiment, the first cooling member 310a is implemented in an "L" shape.

The second cooling member 310b has a shape corresponding to that of the second section 173b. In the present embodiment, the second cooling member 310b is implemented in a rectangular shape.

The first cooling member 310a and the second cooling member 310b may define a relatively large rectangular shape during coupling.

A thickness (t1) of the first cooling member 310a is configured to have a thickness substantially equal to a thickness (t2) of the second cooling member 310b.

According to this configuration, when the operation is initiated, the temperature of the power device 160 on a surface of the first section 173a may be increased by a heating action of the switching device 162a compared to a surface of the second section 173b.

The cooling fluid (L) introduced into the housing 200 is first in contact with the first cooling member 310a to exchange heat. As a result, the cooling of the first section 173a of the power device 160 is initiated. Part of the cooling fluid (L) that has passed through a front end region of the first cooling member 310a (right region on the drawing) is in contact with the second cooling member 310b to exchange heat, and another part of the cooling fluid continues to exchange heat with the first cooling member 310a. As a result, both of the first section 173a and the second section 173b of the power device 160 may exchange heat. At this time, the second cooling member 310b may be configured to have a relatively large porosity while cooling the second section 173b, thereby reducing the occurrence of pressure loss in the cooling fluid (L).

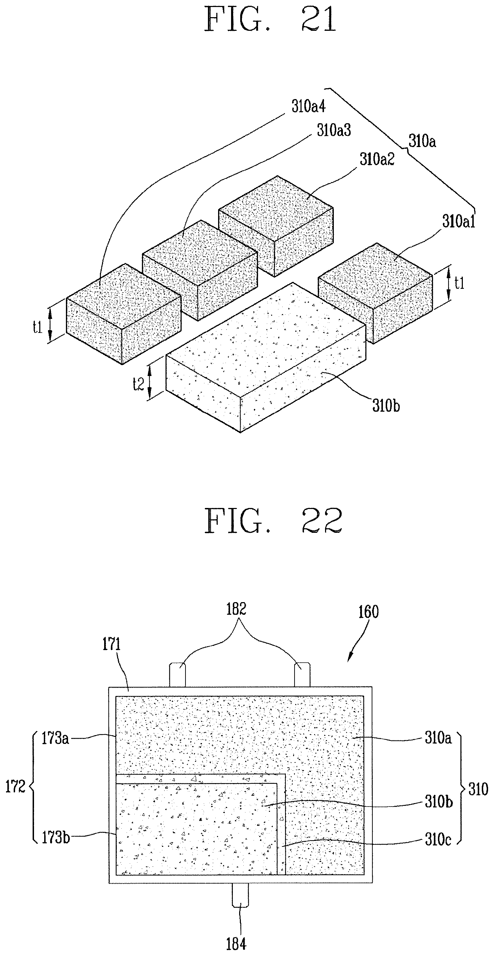

FIG. 20 is a plan view illustrating a coupled state between an electric power module and a cooling member according to still another embodiment of the present disclosure, and FIG. 21 is a perspective view prior to coupling between a first cooling member and a second cooling member in FIG. 20. As illustrated in FIG. 20, the electric power module 150 of this embodiment includes a power device 160, a housing 200 and a cooling member 310.

The power device 160 includes, for example, a body 171, a plurality of circuit devices 162 provided inside the body 171, and metal plates 172 provided on both plate surfaces of the body 171. The plurality of circuit devices 162 are configured with, for example, a plurality of switching devices 162a and a plurality of diodes 162b. The surface of the power device 160 includes a first section 173a configured to have a relatively high temperature and a second section 173b configured to have a lower surface temperature than that of the first section 173a during operation.

Meanwhile, the cooling member 310 is made of a metal foam having a multi porous structure.

The cooling member 310 is implemented to have, for example, a porosity of 0.1 to 0.7. The cooling member may be configured to have a porosity of 0.3 to 0.5.

The cooling member 310 includes, for example, a first cooling member 310a provided in the first section 173a and a second cooling member 310b provided in the second section 173b.

The first cooling member 310a and the second cooling member 310b may have different porosities.

The porosity of the first cooling member 310a may be smaller than that of the second cooling member 310b.

The porosity of the second cooling member 310b may be larger than that of the first cooling member 310a.

As a result, a heat conduction cross-sectional area of the first cooling member 310a may be larger than that of the second cooling member 310b.

Meanwhile, the first cooling member 310a may be configured with a plurality of cooling members 310a1, 310a2, 310a3, 310a4, respectively, disposed to correspond to a surface on which the plurality of switching devices 162a are disposed. In the present embodiment, the first cooling member 310a is implemented with four cooling members 310a1, 310a2, 310a3, 310a4 corresponding to the four switching devices 162a. The first cooling member 310a is implemented in a rectangular parallelepiped shape. The plurality of first cooling members 310a are configured to have substantially the same size.

According to this configuration, a gap between the first cooling members 310a may exist to suppress the occurrence of pressure loss in the cooling fluid (L).

The second cooling member 310b may be configured with one cooling member corresponding to a surface on which the plurality of diodes 162b are disposed. The second cooling member 310b has, for example, a rectangular parallelepiped shape. The second cooling member 310b may be implemented as a rectangular parallelepiped shape having a larger size than the first cooling member 310a.

The first cooling member 310a and the second cooling member 310b may be configured to have the same thickness (t1 = t2) as illustrated in FIG. 21.

In the present embodiment, it is illustrated a case where the first cooling member 310a is implemented with four cooling members corresponding to the four switching devices 162a, but the number of cooling members may be appropriately controlled.

More specifically, the first cooling member 310a may be configured with two cooling members such that one cooling member corresponds to two switching devices 162a. Furthermore, the first cooling member 310a may be implemented with a first cooling member 310a having a relatively large size corresponding to three switching devices 162a and a first cooling member 310a having a relatively small size corresponding to one switching device 162a.

In addition, although the second cooling member 310b is implemented with one cooling members, the number of cooling members may be appropriately controlled.

By this configuration, when the operation is initiated, the cooling fluid (L) is introduced into the housing 200 through the cooling fluid inlet port 241. The cooling fluid (L) introduced into the housing 200 is first in heat exchange with the first cooling member 310a to cool a front end portion of the power device 160. Part of the cooling fluid (L) that has respectively passed through the first cooling member 310a disposed at a front end portion of the power device 160 exchanges heat with another first cooling member 310a, and another part of the cooling fluid (L) exchanges heat with the second cooling member 310b. Accordingly, heat dissipation of the power device 160 is promoted and cooled. At this time, the first cooling member 310a may be divided into a plurality of cooling members (four), thereby suppressing an increase in the pressure loss of the cooling fluid (L).

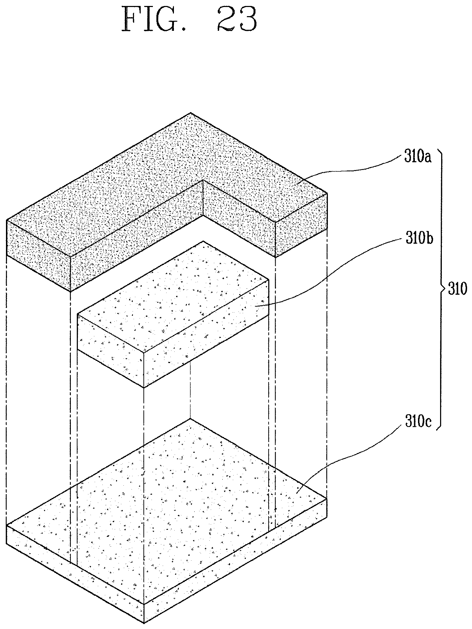

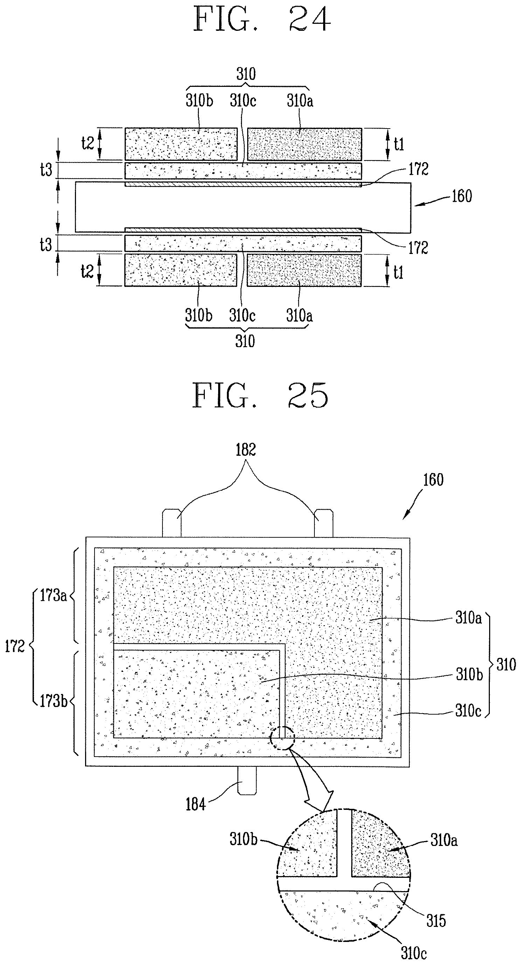

FIG. 22 is a plan view illustrating a coupling state between a power device and a cooling member according to still another embodiment of the present disclosure, and FIG. 23 is a perspective view prior to coupling among a first cooling member, a second cooling member, and a third cooling member in FIG. 22, and FIG. 24 is a cross-sectional view of FIG. 22. As described above, the electric power module 150 of this embodiment includes a power device 160, a housing 200 and a cooling member 310.

As illustrated in FIG. 22, the power device 160 is provided with a body 171, a plurality of circuit devices 162 disposed inside the body 171, and metal plates 172 provided on both plate surfaces of the body 171. The plurality of circuit devices 162 are configured with, for example, a plurality of switching devices 162a and a plurality of diodes 162b, as described above. The surface of the power device 160 includes a first section 173a having a relatively high temperature and a second section 173b having a lower temperature than the first section 173a.

The metal plate 172 of the power device 160 is provided with a cooling member to enable heat exchange.

The cooling member 310 is made of a metal foam having a multi porous structure.

The cooling member 310 is configured to have a porosity of 0.1 to 0.7.

The cooling member 310 includes a first cooling member 310a disposed to correspond to the first section 173a and a second cooling member 310b disposed to correspond to the second section 173b.

The first cooling member 310a exchanges heat with the first section 173a. The second cooling member 310b exchanges heat with the second section 173b.

The cooling member 310 includes a third cooling member 310c in contact with the first cooling member 310a and the second cooling member 310b.

One side of the third cooling member 310c is in contact with the metal plate 172 of the power device 160 and the other side thereof is in contact with the first cooling member 310a and the second cooling member 310b.

The third cooling member 310c is inserted between the power device 160 and the first cooling member 310a and the second cooling member 310b.

The first cooling member 310a and the second cooling member 310b are configured to have a porosity of 0.3 to 0.5.

The first cooling member 310a is configured to have a smaller porosity than the second cooling member 310b.

The third cooling member 310c is configured to have a porosity smaller than that of the first cooling member 310a and the second cooling member 310b.

The third cooling member 310c is configured to have a porosity of 0.1 to 0.3, for example.

More specifically, the first cooling member 310a is configured to have a porosity of 0.3 to 0.4, for example.

The second cooling member 310b may be configured to have, for example, a porosity of above 0.4 and less than 0.5.

The third cooling member 310c may be configured to have a porosity of above 0.1 and less than 0.3.

According to this configuration, a heat conduction cross-sectional area on a surface of the power device 160 may be increased, thereby rapidly cooling the surface of the power device 160.

A heat conduction amount on the surface of the power device 160 may be increased, thereby rapidly decreasing the temperature of the surface of the power device 160.

Furthermore, the first section 173a having a relatively large heat dissipation amount may be rapidly cooled.

In addition, the occurrence of pressure loss in the cooling fluid (L) may be reduced by the second cooling member 310b having a large porosity.

As illustrated in FIG. 23, the first cooling member 310a may be implemented in an "L" shape corresponding to the shape of the first section 173a.

The second cooling member 310b may have a rectangular parallelepiped shape corresponding to the shape of the second section 173b.

The third cooling member 310c may be implemented in a rectangular parallelepiped shape corresponding to the metal plate 172 of the power device 160.

The third cooling member 310c may be configured to be simultaneously in contact with the first section 173a and the second section 173b.

The first cooling member 310a, the second cooling member 310b, and the third cooling member 310c may be configured to have different thicknesses, for example.

As illustrated in FIG. 24, the first cooling member 310a and the second cooling member 310b may be configured to have the same thickness (t1 = t2).

The third cooling member 310c may be configured to have a lower thickness (t3) than the first cooling member 310a and the second cooling member 310b.

As a result, the occurrence of pressure loss in the cooling fluid (L) due to the third cooling member 310c may be suppressed.

In the present embodiment, it is illustrated a case where the first cooling member 310a, the second cooling member 310b, and the third cooling member 310c are configured to have different thicknesses, but it is only an example, and may also be configured to have the same thickness.

In addition, the third cooling member 310c may be configured to have a larger thickness than the first cooling member 310a and the second cooling member 310b.

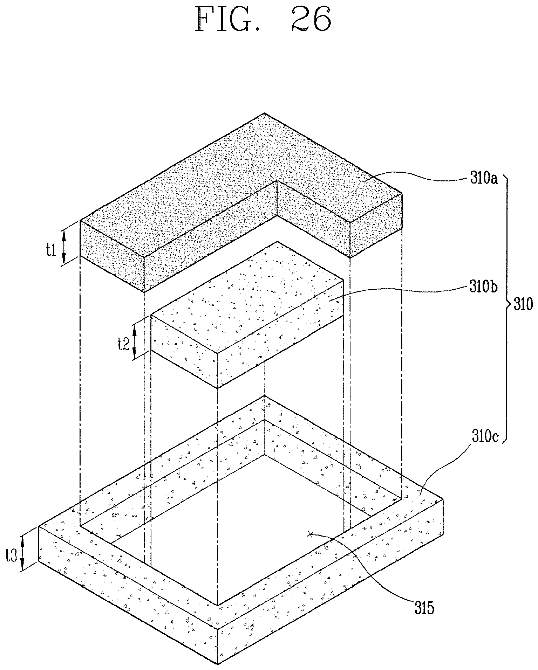

FIG. 25 is a plan view illustrating a coupling state between a power device and a cooling member according to still another embodiment of the present disclosure, and FIG. 26 is a perspective view prior to coupling among a first cooling member, a second cooling member 310b, and a fourth cooling member in FIG. 25. the electric power module 150 of the present embodiment, as described above, may include a power device 160, a housing 200 and a cooling member 310.

As illustrated in FIG. 25, the power device 160 may include a body 171, a plurality of circuit devices 162 provided inside the body 171, and metal plates 172 provided on both plate surfaces of the body 171. The surface of the power device metal plate 172 a first section 173a having a relatively high temperature and a second section 173b having a lower temperature than the first section 173a.

On the other hand, the cooling member 310 is configured such that one side thereof directly exchanges heat with the metal plate 172 of the power device 160 and the other side thereof exchanges heat directly with the cooling fluid (L).

The cooling member 310 is provided with pores and made of a metal foam.

The cooling member 310 is configured to have, for example, a porosity of 0.1 to 0.7.

The cooling member 310 may include a first cooling member 310a exchanging heat with the first section 173a of the power device 160 and a second cooling member 310b exchanging heat with the second section 173b.

The cooling member 310 may include an outer cooling member 310d disposed at an outer edge of the first cooling member 310a and the second cooling member 310b to accommodate the first cooling member 310a and the second cooling member 310b therein.

The first cooling member 310a and the second cooling member 310b are configured to have a porosity of 0.3 to 0.5.

The outer cooling member 310d has a larger porosity than those of the first cooling member 310a and the second cooling member 310b.

The outer cooling member 310d may be configured to have a porosity of 0.5 to 0.7.

According to this configuration, the occurrence of pressure loss in the cooling fluid (L) may be suppressed, and the heat dissipation area of the power device 160 may be increased.

More specifically, the first cooling member 310a may be configured to have a slightly reduced size compared to the size of the first section 173a, for example. The first cooling member 310a may be configured to have an outer border line reduced to a predetermined width compared to that of the first section 173a.

The second cooling member 310b may be configured to have a slightly reduced size compared to the size of the second section 173b, for example. The second cooling member 310b may be configured to include an outer border line reduced to a predetermined width compared to that of the second section 173b.

The third cooling member 310c may include a cooling member accommodating portion 315 capable of accommodating the first cooling member 310a and the second cooling member 310b therein.

The third cooling member 310c may be implemented, for example, in a rectangular ring shape.

The third cooling member 310c may be configured to have, for example, an outer border line slightly larger than that of the first section 173a and the second section 173b.

The third cooling member 310c is configured to have, for example, an outer border line having a size extended to a predetermined width from the outer border lines of the first section 173a and the second section 173b.

As illustrated in FIG. 26, the first cooling member 310a may be implemented in an "L" shape. The second cooling member 310b may be implemented in a rectangular parallelepiped shape. The third cooling member 310c may be implemented in a rectangular ring shape.

The first cooling member 310a and the second cooling member 310b may be configured to have the same thickness.

The thickness (t3) of the third cooling member 310c may be configured to be the same as the thickness (t1) of the first cooling member 310a and the thickness (t2) of the second cooling member 310b.

The first cooling member 310a may be configured to have, for example, a porosity of 0.3 to 0.4.

The second cooling member 310b may be configured to have, for example, a porosity of above 0.4 and less than 0.5.

The third cooling member 310c may be configured to have, for example, a porosity of above 0.5 and less than 0.7.

By this configuration, when the operation is initiated, the cooling fluid (L) is introduced into the housing 200 through the cooling fluid inlet port 241. The cooling fluid (L) introduced into the housing 200 is first in contact with the outer cooling member 310d to exchange heat. Part of the cooling fluid (L) that has passed through the outer cooling member 310d exchanges heat with the first cooling member 310a. Part of the cooling fluid (L) that has passed through the first cooling member 310a exchanges heat with the second cooling member 310b.

In a rear region of the power device 160 along a flow direction of the cooling fluid (L), the first cooling member 310a, the second cooling member 310b, and the outer cooling member 310d are simultaneously in heat exchange with the cooling fluid (L).

The first cooling member 310a has the smallest porosity and the largest heat conduction cross-sectional area, and thus has the largest heat dissipation amount. On the contrary, the greatest pressure loss in the cooling fluid (L) is caused by the first cooling member 310a.

Since the second cooling member 310b has a porosity greater than that of the first cooling member 310a, the heat conduction cross-sectional area is small and thus the heat dissipation amount is relatively small, but the occurrence of pressure loss in the cooling fluid (L) may be reduced.

In addition, since the outer cooling member 310d has a larger porosity than the second cooling member 310b, the heat conduction cross-sectional area is small, but the outer cooling member 310d may be brought into contact with the first cooling member 310a and the second cooling member 310b to increase the heat dissipation area of the power device 160. Since the outer cooling member 310d has the largest porosity, pressure loss in the cooling fluid (L) may be further suppressed.

The cooling fluid (L) that has exchanged heat with the first cooling member 310a, the second cooling member 310b and the outer cooling member 310d continuously cools the power device 160 by repeating a process of being discharged to an outside of the housing 200 through the cooling fluid outlet port 245, and cooled while moving along the movement path of the cooling fluid (L), and then being introduced into the housing 200.

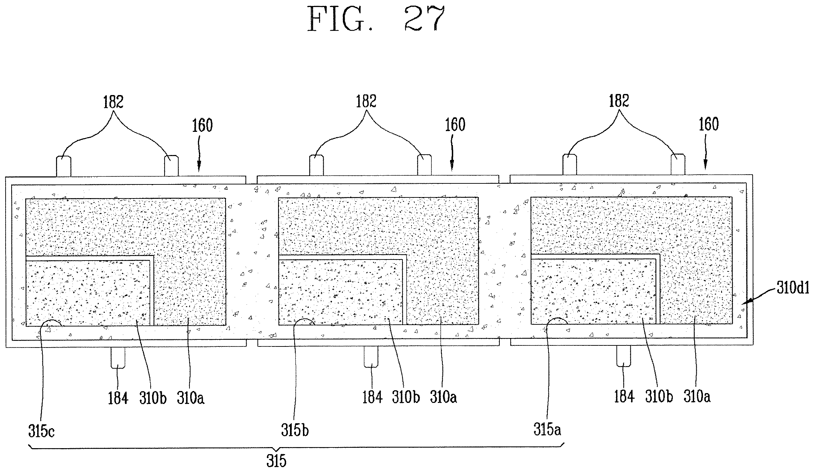

FIG. 27 is a plan view illustrating a coupling state between a power device and a cooling member according to still another embodiment of the present disclosure. the electric power module 150 of the present embodiment, as described above, may include a power device 160, a housing 200 and a cooling member 310.

As illustrated in FIG. 27, the power device 160 may include a body 171, a plurality of circuit devices 162 provided inside the body 171, and metal plates 172 provided on both plate surfaces of the body 171. The plurality of circuit devices 162 are configured with a plurality of switching devices 162a and a plurality of diodes 162b, as described above. The power device 160 includes a first section 173a having a relatively high surface temperature and a second section 173b having a lower temperature than the first section 173a. A plurality of power devices 160 spaced apart along a plate surface direction may be provided.

The cooling member 310 is configured such that one side thereof directly exchanges heat with the metal plate 172 of the power device 160 and the other side thereof exchanges heat directly with the cooling fluid (L).

The cooling member 310 is made of a metal foam having a multi porous structure.

The cooling member 310 is configured to have a porosity of 0.1 to 0.7.

The cooling member 310 may include a first cooling member 310a exchanging heat with the first section 173a of the power device 160 and a second cooling member 310b exchanging heat with the second section 173b.

The first cooling member 310a and the second cooling member 310b are configured to have a porosity of 0.3 to 0.5, for example.

On the other hand, the cooling member 310 may include an outer cooling member 310d disposed at an outer edge of the first cooling member 310a and the second cooling member 310b to accommodate the first cooling member 310a and the second cooling member 310b therein.

The outer cooling member 310d may be configured to have a porosity of 0.5 to 0.7, for example.

The outer cooling member 310d may be configured to have a length corresponding to, for example, three power devices 160.

The outer cooling member 310d may be provided with, for example, a cooling member accommodating portion 315 in which the first cooling member 310a and the second cooling member 310b are accommodated.

The outer cooling member 310d may include a plurality of cooling member accommodating portions 315a, 315b, 315c spaced apart in a length direction.

The outer cooling member 310d may be configured to have three cooling member accommodating portions 315a, 315b, 315c to accommodate the first cooling members 310a and the second cooling members 310b of the three power devices 160, respectively.

As a result, the heat dissipation area of the plurality of power devices 160 may be further expanded.

More specifically, the first cooling member 310a may be configured to have a porosity of 0.3 to 0.4.

The second cooling member 310b may be configured to have, for example, a porosity of above 0.4 and less than 0.5.

The outer cooling member 310d may be configured to have a porosity of above 0.5 and less than 0.7, for example.

By this configuration, when the operation is initiated, the cooling fluid (L) is introduced into the housing 200. The cooling fluid (L) introduced into the housing 200 is first in contact with the outer cooling member 310d to exchange heat. The cooling fluid (L) that has passed through the outer cooling member 310d exchanges heat with the first cooling member, and the cooling fluid (L) that has passed through the first cooling member 310a exchanges heat with the second cooling member 310b. The cooling fluid (L) that has passed through the first cooling member 310a and the second cooling member 310b passes through the outer cooling member 310d again, and then repeats a process of exchanging heat with the first cooling member 310a and the second cooling member 310b.

Thermal energy generated by the plurality of switching devices 162a of the power device 160 is dissipated through the first cooling member 310a and the outer cooling member 310d. Thermal energy generated by the plurality of diodes 162b of the power device 160 is dissipated by the second cooling member 310b and the outer cooling member 310d.

Thermal energy generated by the power device 160 may be intensively dissipated by the first cooling member 310a and the second cooling member 310b, and more quickly dissipated by expanding heat dissipation area through the outer cooling member 310d.

The second cooling member 310b may be disposed in the second section 173b having a relatively small heat dissipation amount, thereby suppressing the occurrence of pressure loss in the cooling fluid (L) while cooling the second section 173b. Furthermore, the outer cooling member 310d may be brought into contact with the first cooling member 310a and the second cooling member 310b to dissipate thermal energy of the power device 160, and configured to have the largest porosity, thereby more effectively suppressing the occurrence of pressure loss in the cooling fluid (L).

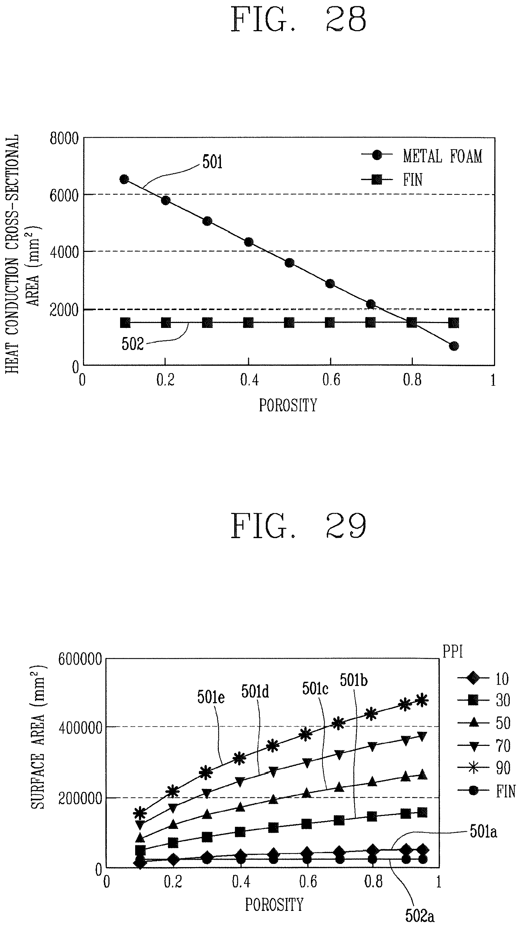

FIG. 28 is a view illustrating a heat conduction cross-sectional area according to a porosity change in the cooling member and cooling pin of the present disclosure. As illustrated in FIG. 28, in a metal foam having a multi porous structure, the heat conduction cross-sectional area decreases as the porosity increases as illustrated in a first graph 501.

On the contrary, in a cooling pin protruded on a surface of the power device 160, the heat conduction cross-sectional area is substantially the same even when the porosity increases as illustrated in a second graph 502.

Here, the cooling pins are considered to have the same cross-sectional area in an entire length along a protruding direction.

The metal foam has a thermal conductivity cross-sectional area that is almost the same as that of a cooling pin in the related art when the porosity is 0.8, and has a smaller thermal conductivity cross-sectional area than the cooling pin in the related art when the porosity exceeds 0.8.

As described above, since the cooling member 310 of the present disclosure is configured to have a porosity of 0.1 to 0.7, it can be seen that the cooling member of the present disclosure has a larger heat conduction cross-sectional area than that of a cooling pin in the related art.

As a result, the heat dissipation amount of the power device 160 through the cooling member 310 may be greater than that of the power device 160 in the related art provided with the cooling pin, and thus the power device 160 may be cooled more quickly.

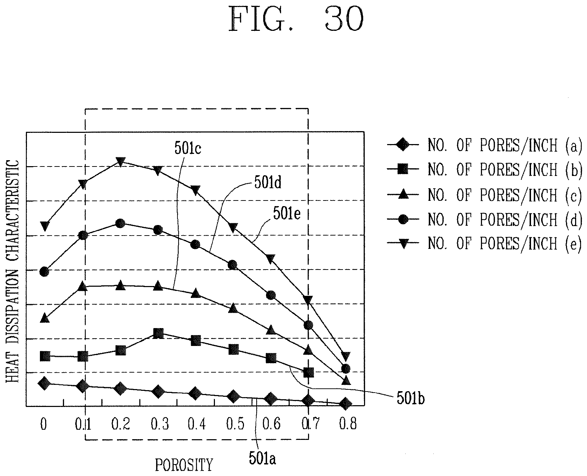

FIG. 29 is a view illustrating a heat transfer surface area of the cooling member of the present disclosure and a cooling pin in the related art, and FIG. 30 is a view illustrating the porosity and the heat dissipation characteristics of the number of holes per inch of the cooling member of the present disclosure.

As illustrated in FIG. 29, the cooling member 310 of the present disclosure, which is made of a metal foam having a multi porous structure, may be configured to have a different surface area of the metal portion 311a according to the number of void holes 311b constituting pores even though the porosity is the same.

When formed of 10 void holes 311b per inch, as illustrated in a first graph 501a, the cooling member 310 has a slightly larger cross-sectional area than the sum of the cross-sectional areas of the cooling pins in the related art, as illustrated in a graph 502a of the cooling pin in the related art.

More specifically, the cooling member 310 of the present disclosure has substantially the same cross-sectional area as that of the cooling pin in the related art when the porosity is 0.1 to 0.3. The cooling member 310 of the present disclosure has a cross-sectional area larger than the sum of the cross-sectional areas of the cooling pins in the related art when the porosity is above 0.4.

For the cooling member 310, as illustrated in second to fifth graphs 501b, 501c, 501d, 501e, when the number of void holes 311b per inch is above 30, a surface area of the metal portion 311a greatly exceeds the sum of the cross-sectional areas of the cooling pins in the related art regardless of the porosity.

For the cooling member 310, it may be seen that the heat transfer area increases as the number of void holes 311b per inch increases.

The cooling member 310 of the present disclosure is composed of 30 to 90 void holes 311b per inch.

As illustrated in FIG. 30, in consideration of the porosity and the number of void holes 311b per inch, for the cooling member 310 of the present disclosure, the heat dissipation characteristic of the cooling member having a substantially large number of void holes 311b per inch is superior to that of a cooling member having a small number of pore holes 311b per inch.

When the number of void holes 311b per inch is 10 (graph 501a), the heat dissipation characteristics gradually decrease as the porosity increases.

When the number of void holes 311b per inch is 30 (graph 501b), the cooling member of the present disclosure has the most excellent heat dissipation characteristic when the porosity is 0.3, and the heat dissipation characteristic gradually decreases as the porosity decreases less than 0.3 or increases more than 0.3.

When the number of void holes 311b per inch is 50 (graph 501c), the cooling member of the present disclosure has an excellent heat dissipation characteristic at a porosity of 0.1 to 0.3, and the heat dissipation characteristic decreases as the porosity decreases less than 0.1 or increases more than 0.4.

When the number of void holes 311b per inch is 70 (graph 501d), the cooling member of the present disclosure has an excellent heat dissipation characteristic at a porosity of 0.2, and the heat dissipation characteristic slightly decreases at a porosity of 0.1 or 0.3, and decreases as the porosity increases more than 0.4.

When the number of void holes 311b per inch is 90 (graph 501e), the cooling member of the present disclosure has the most excellent heat dissipation characteristic at a porosity of 0.2, and the heat dissipation characteristic slightly decreases at a porosity of 0.1 or 0.3, and significantly decreases as the porosity increases more than 0.4.

The cooling member 310 of the present disclosure is configured to have a porosity of 0.1 to 0.7.

The cooling member 310 of the present disclosure is configured with 30 to 90 void holes 311b per inch.

In the foregoing, exemplary embodiments of the present invention have been shown and described. However, the present invention may be embodied in various forms without departing from the spirit or essential characteristics thereof, and accordingly, it is intended that the embodiment described above not be limited by the detailed description provided herein.

Moreover, even if any embodiment is not specifically disclosed in the foregoing detailed description, it should be broadly construed within the scope of the technical spirit, as defined in the accompanying claims. Furthermore, all modifications and variations included within the technical scope of the claims and their equivalents should be covered by the accompanying claims.

## Claims

1. An electric power module (150), comprising:
a power device (160) that converts the frequency of input power for output;
a housing (200) in which a passage of cooling fluid is disposed to accommodate the power device (160) therein, and
a cooling member (310), one side of which is in direct heat exchange with the power device (160), and the other side of which is in direct heat exchange with the cooling fluid,
wherein the cooling member (310) is made of a metal foam having a multi-porous structure.

2. The electric power module (150) of claim 1, wherein the power device (160) is provided with a metal plate (172), and
the cooling member (310) is coupled to the metal plate (172) by soldering or blazing or adhered to the metal plate (172) by a thermal conductive adhesive (168b).

3. The electric power module (150) of claim 1 or 2, wherein the power device (160) is provided with a metal plate (172), and
a thermal interface material (168c) is inserted between the cooling member (310) and the metal plate (172).

4. The power module of any one of claims 1 to 3, wherein the housing (200) is defined such that the passages of cooling fluid are disposed at upper and lower sides of the power device (160), respectively, and
the cooling member (310) comprises an upper cooling member (310U) disposed at an upper side of the power device (160) and a lower cooling member (310L) disposed at a lower side of the power device (160).

5. The electric power module (150) of any one of claims 1 to 4, wherein a plurality of power devices (160) spaced apart along a plate direction are provided, and
a cooling fluid inlet port (241) through which the cooling fluid flows in is disposed on one side along a length direction of the housing (200), and a cooling fluid outlet port (245) through which the cooling fluid flows out is disposed on the other side.

6. The electric power module (150) of claim 5, wherein the porosity of a cooling member (310) close to the cooling fluid inlet port (241) is greater than that of a cooling member (310) close to the cooling fluid outlet port (245).

7. The electric power module (150) of any one of claims 1 to 6, wherein the porosity of the cooling member (310) is 0.1 to 0.7.

8. The electric power module (150) of any one of claims 1 to 7, wherein the power device (160) comprises a first section (173a) having a relatively high surface temperature and a second section (173b) having a lower temperature than the first section (173a), and
the cooling member (310) comprises a first cooling member (310a) in heat exchange with the first section (173a) and a second cooling member (310b) in heat exchange with the second section (173b), and
the porosity of the second cooling member (310b) is larger than that of the first cooling member (310a).

9. The electric power module (150) of claim 8, wherein the cooling member (310) further comprises a third cooling member (310c), one side of which is in contact with the metal plate (172) of the power device (160) and the other side of which is in contact with the first cooling member (310a) and the second cooling member (310b).

10. The electric power module (150) of claim 9, wherein the porosity of the third cooling member (310c) is smaller than that of the first cooling member (310a) and the second cooling member (310b).

11. The electric power module (150) of claim 9 or 10, wherein the porosity of the third cooling member (310c) is more than 0.1 and less than 0.3.

12. The electric power module (150) of any one of claims 8 to 11, wherein the cooling member (310) further comprises an outer cooling member (310d) disposed at an outer edge of the first cooling member (310a) and the second cooling member (310b) to accommodate the first cooling member (310a) and the second cooling member (310b) therein.

13. The electric power module (150) of claim 12, wherein the porosity of the outer cooling member (310d) is larger than that of the first cooling member (310a) and the second cooling member (310b).

14. The electric power module (150) of claim 12 or 13, wherein the porosity of the outer cooling member (310d) is more than 0.5 and less than 0.7.

15. An inverter apparatus, comprising:
a case (110);
an electric power module (150) of any one of claims 1 to 14 provided inside the case (110); and
a DC-link capacitor (390) provided inside the case (110) to provide DC power to the electric power module (150).
